Europäisches Patentamt

European Patent Office

Office européen des brevets

(11) Publication number: **0 161 023**
**B1**

(12) **EUROPEAN PATENT SPECIFICATION**

(45) Date of publication of patent specification: **19.07.89**

(51) Int. Cl.⁴: **H 04 N 3/15, G 11 C 19/28, G 11 C 27/00, H 01 L 27/14**

(21) Application number: **85200579.2**

(22) Date of filing: **16.04.85**

(54) **Charge-coupled semiconductor device with dynamic control.**

<table>
<tr><td>

(30) Priority: **24.04.84 NL 8401311**

(43) Date of publication of application:
**13.11.85 Bulletin 85/46**

(45) Publication of the grant of the patent:
**19.07.89 Bulletin 89/29**

(84) Designated Contracting States:
**AT DE FR GB IT NL SE**

(56) References cited:
**US-A-3 911 290**
**US-A-4 178 614**

</td><td>

(73) Proprietor: **N.V. Philips' Gloeilampenfabrieken**
**Groenewoudseweg 1**
**NL-5621 BA Eindhoven (NL)**

(72) Inventor: **Boudewijns, Arnoldus Johannes J.**
**c/o INT. OCTROOIBUREAU B.V. Prof. Holstlaan 6**
**NL-5656 AA Eindhoven (NL)**
Inventor: **Esser, Leonard Jan Maria**
**c/o INT. OCTROOIBUREAU B.V. Prof. Holstlaan 6**
**NL-5656 AA Eindhoven (NL)**

(74) Representative: **Houbiers, Ernest Emile Marie**
**Gerlach et al**
**INTERNATIONAAL OCTROOIBUREAU B.V. Prof.**
**Holstlaan 6**
**NL-5656 AA Eindhoven (NL)**

</td></tr>
</table>

Courier Press, Leamington Spa, England.

**Description**

The invention relates to a charge-coupled semiconductor device, comprising a semiconductor body in which at a major surface at least one charge transport channel is defined, and which is provided at said surface with a row of electrodes at which a control signal for charge storage and a clock signal for charge transport can be supplied, at least one shift register being provided which can be controlled by a mono- or multiphase clock and which has several stages, the electrodes of said row being separately connected in an electrically conducting manner to stages of the shift register.

Such charge-coupled semiconductor devices are used in various fields of the technique, for example, as image sensor devices in solid state cameras, in which information is generated in a radiation-sensitive part and is then stored, if required, in a memory part. The information may then be covered by electronic means into a television signal, but may also be stored temporarily, for example on a memory disk or memory tape.

A device of the kind mentioned in the opening paragraph is described in the US-patent US—A—4.178.614 which discloses an image sensor device of high resolution, in which the quantity of semiconductor surface area used is considerably reduced by separately driving the electrodes by which potential wells for charge storage and charge transport are generated in the semiconductor body. In the embodiment shown therein, the electrodes are driven from registers in such a manner that either a clock signal or an adjustment signal is supplied at the electrodes of the image sensor device. The adjustment signal is then variable. The sensor comprises at least one shift register which can be controlled by a mono- or multiphase clock and has several stages, in which the electrodes are separately connected in an electrically conducting manner to stages of the shift register.

It should be noted that due to the periodicity of the shift registers such stages can be defined differently. An electrode may then be connected in one case to, for example, an output of such a stage and in another case to an input or even to a quite different part of the stage. As will appear from one of the embodiments, under given conditions the input terminal of the shift register should be considered to form part of the first stage because an electrode is connected thereto, in an electrically conducting manner.

The space in which a stage of the shift register is realized will generally have a larger width or length than the distance between two successive electrodes of the charge-coupled device. This means that, with a fixed dimension of a shift register stage, $n$ electrodes of the charge-coupled device being arranged in the transport direction within one stage of the shift register, $n$ stages would have to lie beside these $n$ electrodes, each of the stages then driving an electrode.

A charge-coupled device according to the invention is characterized in that said shift register is divided into a plurality of sub-shift registers which are realized on both sides of the row of electrodes, wherein two subsequent subregisters provided on different sides of the row of electrodes are interconnected by one electrode of said row of electrodes.

In order to gain some room and to reduce problems with respect to wiring, regularly (for example every third or fourth stage) one of the electrodes of the electrode system is preferably used as through-connection of two stages of the shift register. Besides $n$ electrodes, each time n/2 stages of the shift register each time realized on both sides of the electrode system.

The shift register used is preferably a dynamic shift register because this register can be realized on a smaller surface.

In this connection, a dynamic shift register is to be understood to mean any switching device comprising several parts or stages, in which corresponding parts or stages are switched on and off synchronously by clock signals, while between different clock signals the information in the parts or stages is retained by means of capacitive charge capacitive charge storage.

The shift register may be realized in various ways, for example, so as to comprise several inverter circuits which are interconnected by means of switching transistors, which are controlled by the clock signal. The charge determining the state of the inverter circuit is then stored, for example, on a parasitic capacitance of this circuit, while the output is connected to an electrode of the charge-coupled semiconductor device.

A preferred embodiment of such a device according to the invention is characterized in that the inverter circuit is realized by means of complementary MOS transistors. This has the advantage that a stage of the shift register can be realized with only three transistors.

The stges of the shift register need not necessarily be inverting. However, since all outputs can then be simultaneously high or low, in this case at least two shift registers are required, which are then also advantageously realised on both sides of the row of electrodes.

The invention will now be described more fully with reference to a few embodiments and the drawing in which:

Figures 1$^a$ to 1$^m$ show the principle of charge storage and charge transport, according to which a device in accordance with the invention operates:

Figure 2 shows diagrammatically in plan view an image sensor device according to the invention;

Figure 3 shows diagrammatically a shift register controlled by a two-phase clock signal by which the device shown in Figure 2 can be controlled;

Figure 4 shows a variation of the device shown in Figure 3;

Figure 5 shows a possible embodiment of a shift register for the device shown in Figures 2, 3 and 4;

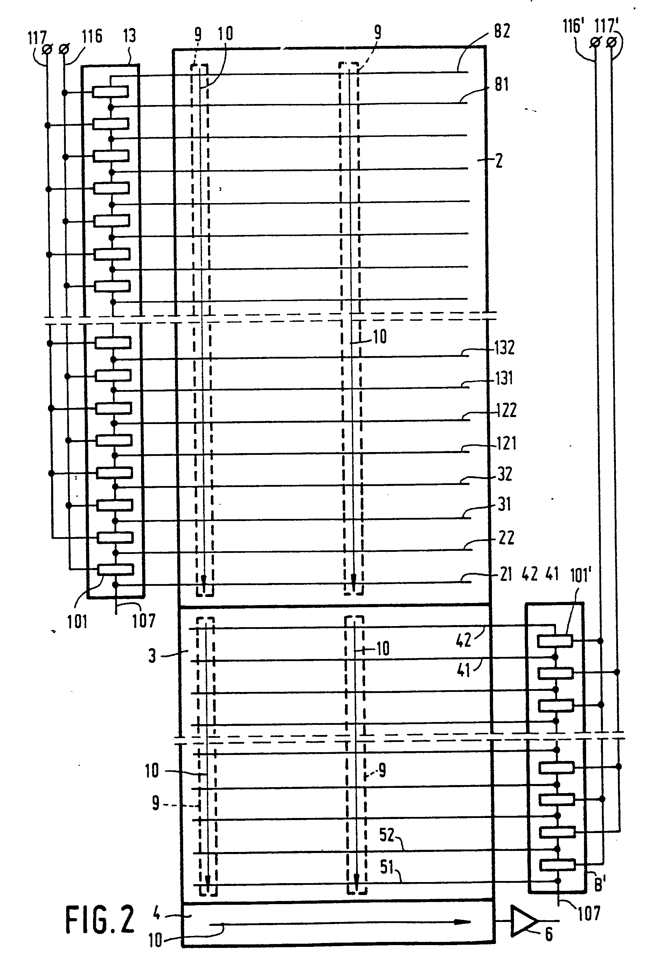

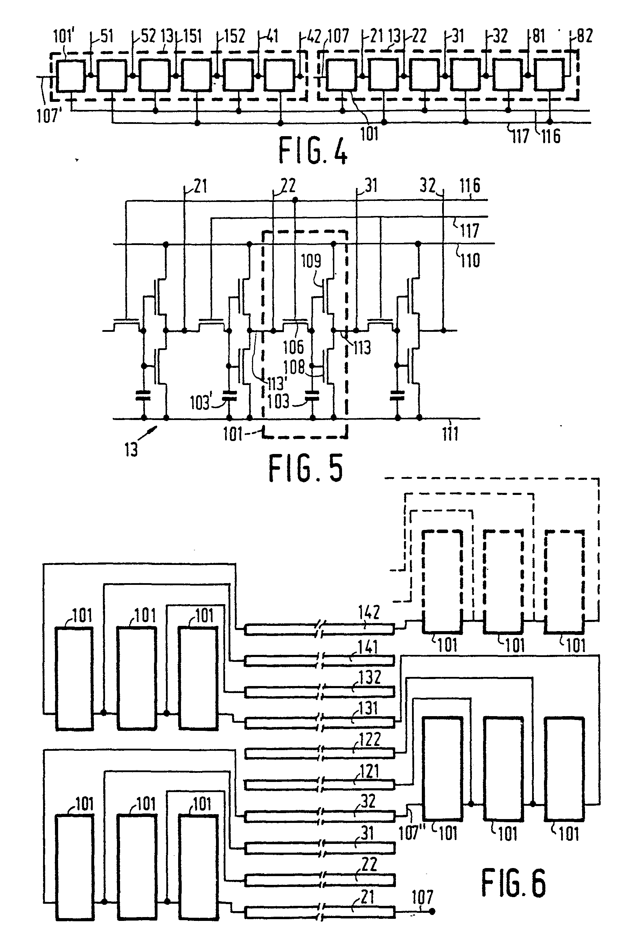

.Figure 6 shows a variation of a part of the device shown in Figure 2;

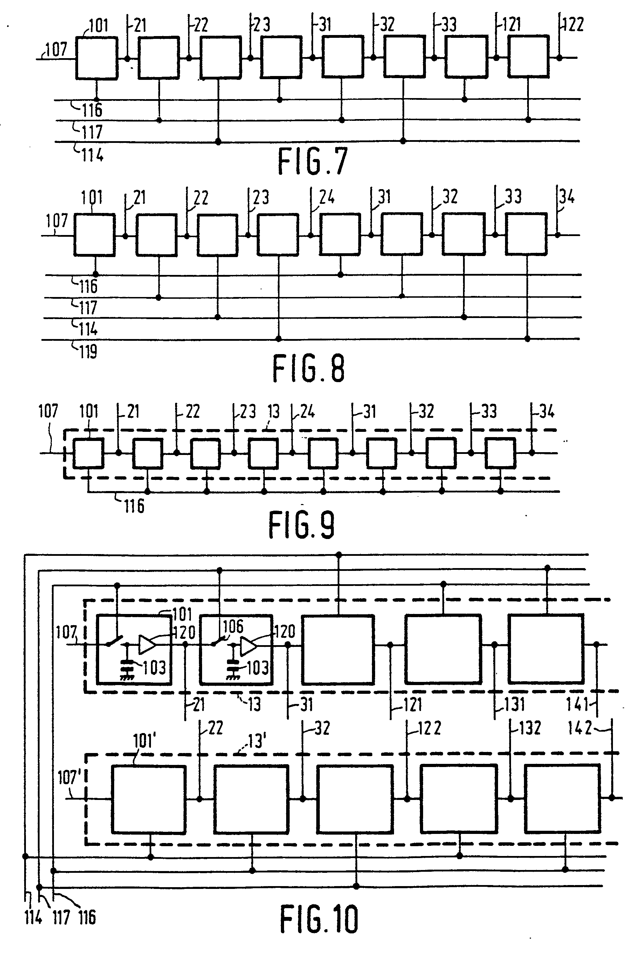

Figure 7 shows a variation of the shift register, in which the shift register is controlled by a three-phase clock signal;

Figure 8 shows a variation of the shift register, in which this shift register is controlled by a four-phase clock signal;

Figure 9 shows a variation of the shift register, in which this shift register is controlled by a monophase clock signal;

· Figure 10 shows two shift registers comprising non-inverting stages for controlling the device shown in Figure 2, while

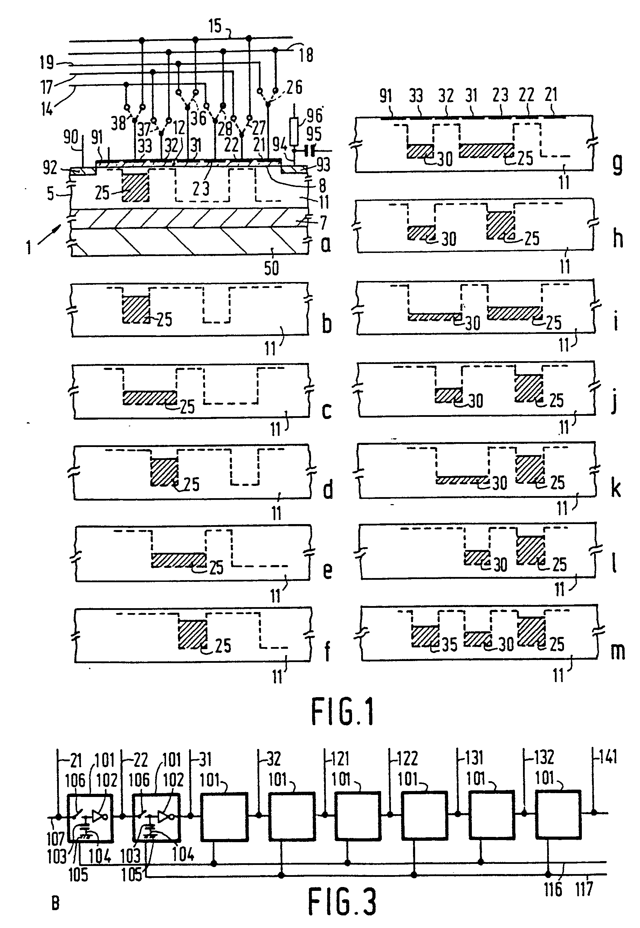

Figure 1 shows a possible embodiment of such a shift register and

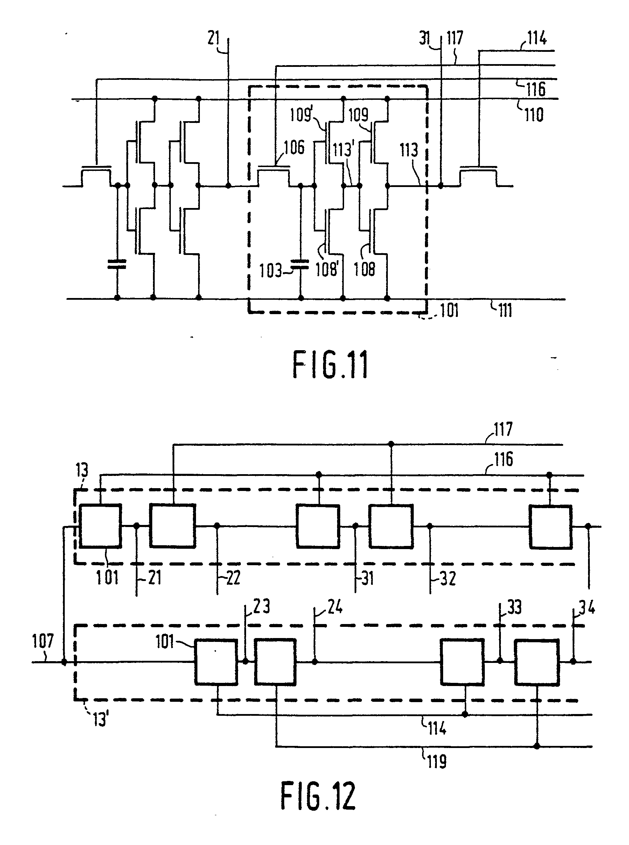

Figure 12 shows two shift registers comprising inverting stages for controlling a device shown in Figure 2.

The Figures are schematic and not drawn to scale, whilst for the sake of clarity in the cross-sections especially the dimensions in the direction of thickness are greatly exaggerated. Semiconductor zones of the same conductivity type are generally cross-hatched in the same direction; in the Figures, corresponding parts are generally designated by the same reference numerals.

The principle on which the operation of a device according to the invention is based will first be explained more fully with reference to Figure 1, in which a charge-coupled semiconductor device 1 is represented which comprises a semiconductor body 5. The semiconductor body 5, is composed, for example, of a silicon substrate 50 of the $n$-type having a resistivity of approximately 10 $\Omega \cdot$ cm and a $p$-type region 7 provided therein having a doping of approximately $3 \cdot 10^{15}$ atoms/cm$^3$. At the major surface 8, the semiconductor body comprises at least one charge transport channel, in this case constituted by the $n$-type region 11 having a thickness of approximately 1 μm and an average impurity concentration of approximately $10^{16}$ atoms/cm$^3$.

The major surface 8 is covered by a layer 12 of insulating material, for example silicon oxide. There are provided on and in this insulating layer 12 a number of electrodes 21, 22, 23, 31, 32, 33, by means of which potential wells can be produced in the semiconductor material for charge storage and charge transport.

According to the invention, in the device shown, each of the electrodes 21, 22, 23, 31, 32, 33 can be switched so that a clock pulse signal or an adjustment signal (reference level) is supplied. For this purpose, the device is provided with switching elements 26, 27, 28, 36, 37, 38, by which the electrodes can be separately switched between clock pulse lines (signal lines) 1 14, 17, 19 and adjustment lines (reference lines) 15, 18. The switching elements are controlled by means of registers to be described more fully.

Further, the device is provided with an $n$-type source zone 92, at which an input signal can be supplied via a connection 90. If the voltage at the gate electrode 91 is sufficiently high, a charge packet 25, whose size depends upon the input signal, can be transferred to a potential well under the electrode 33, which for this purpose also has a high voltage. Reading of information under the electrode 21 can be effected in a generally known manner, for example, by means of an RC network comprising a resistor 96 and a capacitor 95 and connected to the adjoining $n$-type region 93.

In Figures 1$^a$ to 1$^m$, broken lines indicate at different instants the variation of the surface potential as it occurs due to voltages at the electrodes 21, 22, 23, 31, 32, 33 and 91. The potential variation is then represented in a generally known manner so that potential wells or troughs correspond to energy minima for electrons, so to parts of the semiconductor body which are located under an electrode at high voltage.

The broken line of Figure 1$^a$ corresponds to the potential variation as it occurs at an instant $t_1$ when the electrodes 21, 22, 23, 31, 32, 33 are connected via the switching elements 26, 27, 28, 36, 37, 38 to such clock pulse signals at the lines 14, 17, 19 that potential wells are situated under the electrodes 21, 23, 31 and 33 and potential barriers for electrons are situated under the electrodes 22, 32. Due to the fact that immediately before the instant $t_1$ the voltage at the electrode 91 has been high for some time, a charge packet 25 has been transferred to the potential well under the electrode 33. The size of the charge packet depends upon the input signal at the connection 90 of the $n$-type region 92 and upon the duration for which the electrode 91 has been at a high voltage. The potential wells under the electrodes 31, 23 and 21 are assumed to contain no charge or a negligibly small quantity of charge at the instant $t_1$.

Figure 1$^b$ shows the potential variation in the device at the instant $t_2$ when due to clock signals at the lines 14, 17, 19 such voltages are supplied at the electrodes 21, 22, 23, 31, 32, 33 that potential wells are situated under the electrodes 23 and 33, while potential barriers are situated under the remaining electrodes; therefore, the charge packet 25 is maintained under the electrode 33.

At the instant $t_3$ (Figure 1$^c$) the potential variation changes in such a manner that potential wells are formed under the electrodes 22, 23, 32, 33 and potential barriers are formed under the electrodes 21, 31. Consequently, the charge packet 25 is distributed over the potential wells under the electrodes 32, 33.

Figure 1$^d$ shows the potential variation at the instant $t_4$ when due to the clock voltages at the lines 4, 17, 19 potential wells are situated under the electrodes 22, 23 and potential barriers are situated under the electrodes 21, 23, 31, 33. The charge packet 25 is now situated under the electrode 32 and has consequently shifted through one electrode distance with respect to the situation at the instant $t_1$ (Figure 1$^a$).

At the instant $t_5$ (Figure 1$^e$), potential barriers are situated under the electrodes 33 and 23. The charge packet 25 is situated in the potential well under the electrodes 31, 32. The potential well under the electrodes 21, 22 is assumed to contain no charge. Consequently, no output signal is detected either in the output circuit comprising *inter alia* the capacitance 95 and the resistor 96. Also at the instant $t_6$, when potential wells are situated under the electrodes 31 where the charge packet 25 is located (Figure 1$^f$), the potential well under the electrode 21 does not contain charge so no output signal is detected either.

In Figure 1$^g$, the potential variation due to clock signals at the lines 14, 17, 19 is represented at an instant $t_7$ which is analogous to that at the instant $t_1$ (Figure 1$^a$). In the same manner as described with reference to Figure 1a, a charge packet 30 is now generated under the electrode 33; the charge packet 25 is meanwhile located in a potential well under the electrodes 23, 31.

At the instants $t_8$, $t_9$, $t_{10}$ (Figures 1$^h$, 1$^i$, 1$^j$), analogous potential variations to those at the instants $t_2$, $t_3$, $t_4$ (Figures 1$^b$, 1$^c$, 1$^d$) occur in the semiconductor body. This results in that at the instant $t_{10}$ the charge packets 25 and 30 are concentrated in potential wells under the electrodes 22 and 32.

Without further steps being taken, at the instant $t_{11}$ due to clock voltages at the lines 14, 17, 19 the potential variation of the instant $t_5$ (Figure 1$^e$) would return; in other words: a potential well would be formed under the electrodes 21, 22, in which the charge packet 25 would be distributed. The charge variation under the electrode 21 would then give rise *via* the output circuit to an output signal at the capacitance 95.

For various reasons, it may be desirable that this does not happen immediately, for example, if the semiconductor device is used as a delay line and the information should be processed in the form of stored charge at a later instant or if several of such devices are arranged in a multiplex circuit, in which event the information can be read arbitrarily from one of the charge-coupled devices.

In order to prevent an output signal from being generated, the charge packet 25 is continuously concentrated under the electrode 22 in that before the instant $t_{11}$ a potential barrier is formed under the electrode 21. This is achieved in that the electrode 21 is connected *via* a switching element 26 to an adjustment line (reference line) 18, which has a low potential. The potential variation on the lefthand side of the electrode 21 is determined by clock voltages at the lines 14, 17, 19 (see Figure 1$^k$) and is now analogous to that at the instant $t_5$ (Figure 1$^e$) so that potential wells are formed under the electrodes 22, 31, 32 and potential barriers are formed under the electrodes 23, 33.

In order to maintain a potential well for the charge packet 25, a high potential is supplied at the electrode 22 according to the said Patent Application by connecting the electrode 22 *via* a switching element 27 to an adjustment line (reference line) 15 at high potential (see Figure 1$^l$) (instant $t_{12}$). On the lefthand side of the electrode, the potential variation is now analogous to that of Figure 1$^f$ (instant $t_6$).

At the instant $t_{13}$ (Figure 1$^m$), the electrode 23 is a low adjustment signal (*via* switching element 28 and reference line 18). As a result, a potential barrier is formed under the electrode 23 between the potential well under the electrode 22 and a potential well to be formed anew under the electrode 31 for the charge packet 30, which is realized in that at a next instant $t_{14}$ the electrode 31 is no longer determined by the clock pulse voltages, but (*via* switching element 37) has a high voltage.

At the instant $t_{13}$ the potential variation under the electrodes 31, 32, 33 is still determined by clock signals at the lines 14, 17, 19 and in the same manner as in Figure 1$^a$ a charge packet 35 is generated under the electrode 33. After at $t_{14}$ the electrode 31 has been connected to a high adjustment signal, at following instants the electrodes 32 and 33 are connected to a low and a high adjustment signal (reference level), respectively. The said Patent Application further describes how the information in the form of charge packets can be read in that by means of the switching elements 26, 27, 28, 36, 37, 38 the electrodes 21, 22, 23, 31, 32, 33 are connected gradually in the desired order of succession again to the lines 14, 17, 19 for charge transport by means of clock pulse signals at these lines.

In order to simplify the further description of the device according to the invention, the potential variation at the instants $t_1$ to $t_{16}$, as shown in Figure 1, is represented below in the form of a table (Table 1); in this Table, a "1" corresponds to a high voltage at the electrodes, whereas a "0" corresponds to a low voltage at the electrodes.

TABLE 1

| Instant | Electrodes | | | | | | Figure |
|---|---|---|---|---|---|---|---|
| $t_1$ | 1 | 0 | 1 | 1 | 0 | 1 | 1a |
| $t_2$ | 1 | 0 | 0 | 1 | 0 | 0 | 1b |
| $t_3$ | 1 | 1 | 0 | 1 | 1 | 0 | 1c |
| $t_4$ | 0 | 1 | 0 | 0 | 1 | 0 | 1d |
| $t_5$ | 0 | 1 | 1 | 0 | 1 | 1 | 1e |
| $t_6$ | 0 | 0 | 1 | 0 | 0 | 1 | 1f |
| $t_7$ | 1 | 0 | 1 | 1 | 0 | 1 | 1g |
| $t_8$ | 1 | 0 | 0 | 1 | 0 | 0 | 1h |
| $t_9$ | 1 | 1 | 0 | 1 | 1 | 0 | 1i |
| $t_{10}$ | 0 | 1 | 0 | 0 | 1 | 0 | 1j |
| $t_{11}$ | 0 | 1 | 1 | 0 | 1 | 0 | 1k |
| $t_{12}$ | 0 | 0 | 1 | 0 | 1 | 0 | 1l |
| $t_{13}$ | 1 | 0 | 1 | 0 | 1 | 0 | 1m |
| $t_{14}$ | 1 | 0 | 1 | 0 | 1 | 0 | 1m |
| $t_{15}$ | 1 | 0 | 1 | 0 | 1 | 0 | 1m |
| $t_{16}$ | 1 | 0 | 1 | 0 | 1 | 0 | 1m |

In Table 1, broken lines indicate how the charge packet is first displaced by alternating voltages from a potential well under the electrode 33 to an area under the electrode 22, after which from $t_{10}$ by a gradual fixing of the electrode voltages by means of adjustment signals this charge packet 25 is stored under the electrode 22 and the charge packets 30, 35 are stored under the electrodes 31, 33. In the part of the table located on the righthand side below the dot-and-dash line, the electrode voltages for these adjustment signals are kept at a constant potential.

Figure 2 shows in principle a circuit diagram of an image sensor device according to the invention, in which switching elements 26, 27, 28, 36, 37, 38 of the kind shown in Figure 1, just like the reference lines 15, 18, may be emitted because the electrodes of the electrode system are directly controlled by the outputs of a dynamic shift register. In this case, the device is an image sensor device 1 of the so-called Frame Field Transfer type. Such an image sensor device comprises a radiation-sensitive sensor part 2, in which during a given exposure period a pattern of electric charge carriers corresponding to the radiation image is formed. After the exposure period, the pattern of electric charge carriers is stored temporarily in the memory part 3, from which the part is sequentially read by means of one or more shift registers 4. This reading can be effected by means of techniques known per se. If desired, the signals obtained may be amplified by means of the amplifier 6 shown diagrammatically before being further processed.

The image sensor device comprises (in the same manner as in Figure 1) a semiconductor body which is composed, for example, of a silicon substrate of the n-type and a p-type region provided therein. The p-type region may be provided, for example, by means of ion implantation followed by a diffusion step. At the major surface of the semiconductor body there are defined a number of mutually separated substantially parallel extending charge transport channels (designated in Figure 2 by reference numeral 9), in which charge transport can take place, as shown diagrammatically in Figure 2 by means of arrows 10. In the present case, the charge transport device or CCD is formed by a CCD with bulk transport (PCCD or BCCD). The charge transport channels are then constituted by n-type regions 11, which are mutually separated by p-type regions and have a depth of about 1 μm, while their width amounts to approximately 5 μm.

The major surface 8 (see Figure 1) is covered by a layer 12 of insulating material, for example silicon oxide. On and in this layer 12 are formed a number of electrodes, by means of which potential wells can be produced in the semiconductor material for charge storage and charge transport.

In the device shown in Figure 2, which is suitable for four-phase transport, each so-called "storage element" in a channel 9, 11 of the sensor part 2 comprises two transport electrodes 21, 22, 31, 32, 121, 122, 131, 132 and 141, 142, respectively, which are common to "storage elements" in several channels. Similarly, in the storage part 3 such "storage elements" are formed by means of transport electrodes 41, 42 and 51, 52, respectively, etc. As a matter of course, the device comprises a considerably larger number of electrodes than are shown here. In an image sensor device for the so-called PAL system, both the sensor part and the memory part comprise about 600 transport electrodes corresponding to 300 "storage elements" per charge transport channel.

In order to be able to drive in the device selectively the electrodes of the charge-coupled device 1, the latter has shift registers 13, 13', which in this embodiment are composed of inverter stages 101. According to the invention, the electrodes 22, 31, 32, 121, 122, 131, 132, 141 etc. of the image sensor part 2 are connected directly in an electrically conducting manner to outputs of the inverter stages 101, while the electrode 21 is connected to the input terminal 107 (and hence to the first stage) of the shift register 13.

In the same manner, electrodes 52..., 41, 42, of the memory part 3 are connected in an electrically conducting manner to outputs of stages 101' of a second register 13', which controls the memory part 3. In this case, the transport electrode 51 is connected to the input terminal 107' of the shift register 13'.

A stage 101 of the register 13 in this embodiment consists of an inverter circuit 102, which is connected via a switching element 106 (for example a MOS transistor) to an input signal. For the first stage of the register 13 the input signal is supplied at the input terminal 107, while for the remaining stages the input voltage is supplied by the output of a preceding stage. Each of the stages retains its voltage at the output via a generally parasitic capacitance 103 at the input of the inverter circuit 102, which in Figure 2 is connected diagrammatically via a lead 104 to an earth contact 105. This capacitance is sufficiently large to retain for a sufficiently long time the desired potential at the output. The switching elements 106 are switched on and switched off by means of clock voltages at the clock lines 116, 117. If, for example, the clock line 116 is switched so that the switching elements 106 are closed, the output of the first stage reaches a level (high (1) or low (0)) which is determined by the signal at the input terminal 107. The output of the second stage remains unchanged, just like all the other outputs of stages controlled by the clock lines 117. The outputs of all the other stages controlled by the clock line 116 may change dependent upon the levels at the outputs of the preceding stages. For a more extensive description of dynamic shift registers of this kind, reference may be made to the book "MOS Integrated Circuits" by W. M. Penney and L. Lau, published in 1979 by R. E. Krieger Publishing Company, more particularly p. 260 ff.

It is possible to effectively throughconnect the stages 101 in the register 13 by activating clock signals at the clock line 116 and the clock line 117 simultaneously so that at a low level (0) at the input terminal 107 a 010101010 pattern is obtained at the electrodes 21, 22, 31, 32, 121, 122, 131, 132, 141 (see Table 2, line a).

If this pattern is maintained, integration takes place in the image sensor part 2 under the even-numbered electrodes 22, 32, 122, 132; when a high level (1) is supplied at the input terminal 107, a complementary pattern can be obtained at the electrodes so that integration is possible under the oddnumbered electrodes (21, 31, 121, 131, 141).

By further processing, the stored charge, which corresponds to a sensed image, is in fact generally converted into a signal for a television receiver. It is then common practice to activate alternately the even-numbered and the odd-numbered lines of the image screen. For this so-called interlacing, it is therefore desirable that within one image period (1/30—1/25 sec) a transfer from the radiation-sensitive part to a storage register takes place twice, the charge storage occurring alternately in different parts of the radiation-sensitive part. For this purpose, in the relevant image sensor device, the charge packets within one image period are collected alternately at different areas, i.e. alternately under the electrodes 21, 31, 121 etc., and the electrodes 22, 23, 122 etc.

At the instant $t_1$ (Table 1, Figures 2, 3), the electrodes 22, 32, 122, 132 have a high potential, in other words; under these electrodes are situated potential wells in which charge generated by incident radiation is collected. Due to the fact that the voltage at the input terminal 107 does not change during the instants $t_2$, $t_3$, this situation is maintained (lines a, b, c).

At the instant $t_4$, the signal at the input terminal 107 becomes high (1). Due to the fact that the clockline 116 ($\varphi_1$) is not active, the output of the first stage does not change. However, the potential well under the electrode 22 is effectively doubled due to the fact that now a potential well is situated under the electrodes 21, 22 over which this charge is distributed (line d).

## EP 0 161 023 B1

TABLE 2

| Instant | Clock | Input (107) electrode 21 | 22 | 31 | 32 | Electrodes 121 | 122 | 131 | 132 | 141 | Line |
|---------|-------|--------------------------|----|----|----|-----|-----|-----|-----|-----|------|
| $t_1$ | $\varphi_1$ | 0 | 1 | 0 | 1 | 0 | 1 | 0 | 1 | 0 | a |
| $t_2$ | $\varphi_2$ | 0 | 1 | 0 | 1 | 0 | 1 | 0 | 1 | 0 | b |
| $t_3$ | $\varphi_1$ | 0 | 1 | 0 | 1 | 0 | 1 | 0 | 1 | 0 | c |
| $t_4$ | $\varphi_2$ | 1 | 1 | 0 | 1 | 0 | 1 | 0 | 1 | 0 | d |
| $t_5$ | $\varphi_1$ | 1 | 0 | 0 | 1 | 0 | 1 | 0 | 1 | 0 | e |
| $t_6$ | $\varphi_2$ | 0 | 0 | 1 | 1 | 0 | 1 | 0 | 1 | 0 | f |
| $t_7$ | $\varphi_1$ | 0 | 1 | 1 | 0 | 0 | 1 | 0 | 1 | 0 | g |
| $t_8$ | $\varphi_2$ | 1 | 1 | 0 | 0 | 1 | 1 | 0 | 1 | 0 | h |
| $t_9$ | $\varphi_1$ | 1 | 0 | 0 | 1 | 1 | 0 | 0 | 1 | 0 | i |
| $t_{10}$ | $\varphi_2$ | 0 | 0 | 1 | 1 | 0 | 0 | 1 | 1 | 0 | j |
| $t_{11}$ | $\varphi_1$ | 0 | 1 | 1 | 0 | 0 | 1 | 1 | 0 | 0 | k |
| $t_{12}$ | $\varphi_2$ | 1 | 1 | 0 | 0 | 1 | 1 | 0 | 0 | 1 | l |
| $t_{13}$ | $\varphi_1$ | 1 | 0 | 0 | 1 | 1 | 0 | 0 | 1 | 1 | m |
| $t_{14}$ | $\varphi_2$ | 0 | 0 | 1 | 1 | 0 | 0 | 1 | 1 | 0 | n |
| $t_{15}$ | $\varphi_1$ | 0 | 1 | 1 | 0 | 0 | 1 | 1 | 0 | 0 | o |
| $t_{16}$ | $\varphi_2$ | 1 | 1 | 0 | 0 | 1 | 1 | 0 | 0 | 1 | p |
| $t_{17}$ | $\varphi_1$ | 1 | 0 | 0 | 1 | 1 | 0 | 0 | 1 | 1 | q |
| $t_{18}$ | $\varphi_2$ | 1 | 0 | 1 | 1 | 0 | 0 | 1 | 1 | 0 | r |
| $t_{19}$ | $\varphi_1$ | 1 | 0 | 1 | 0 | 0 | 1 | 1 | 0 | 0 | s |
| $t_{20}$ | $\varphi_2$ | 1 | 0 | 1 | 0 | 1 | 1 | 0 | 0 | 1 | t |
| $t_{21}$ | $\varphi_1$ | 1 | 0 | 1 | 0 | 1 | 0 | 0 | 1 | 1 | u |
| $t_{22}$ | $\varphi_2$ | 1 | 0 | 1 | 0 | 1 | 0 | 1 | 1 | 0 | v |
| $t_{23}$ | $\varphi_1$ | 1 | 0 | 1 | 0 | 1 | 0 | 1 | 0 | 0 | w |
| $t_{24}$ | $\varphi_2$ | 1 | 0 | 1 | 0 | 1 | 0 | 1 | 0 | 1 | x |
| $t_{25}$ | $\varphi_1$ | 1 | 0 | 1 | 0 | 1 | 0 | 1 | 0 | 1 | y |
| $t_{26}$ | $\varphi_2$ | 1 | 0 | 1 | 0 | 1 | 0 | 1 | 0 | 1 | z |

At the instant $t_5$, the output of the first stage becomes low (0) by the activation of the clock line 116 ($\varphi_1$) the input signal is still high (1). As a result, the said charge is shifted to a potential well under the electrode 21 (line e) because the electrode 22 becomes low (0).

7

At the instant $t_6$ (line $f$), the input terminal has become low (0), but this does not influence the output of the first stage because $\varphi_1$ (clock line 116) is not active. However, the potential well under the electrode 21 has disappeared, but due to a satisfactory synchronization between the registers 13, 13' a potential well has formed under the electrodes 41, 42 in the memory part 3 (Figure 2) in which the charge from this potential well has been stored. Due to the fact that $\varphi_2$ (clock line 117) is now active, the change of the output voltage of the first stage, in other words the voltage at the electrode 22, is passed on *via* the inverter stage to the third stage so that the electrode 31 becomes high (1), while $\varphi_2$ does not influence the electrode 32, which remains high (1).

In substantially the same manner as described with reference to Figure 1 and Table 1, the charge packets situated under the even-numbered electrodes 22, 32, 122, 132 are new transported to a memory part by generating with a suitably chosen alternation of the signal at the input terminal 107 such a pattern at the electrodes 21, 22, 31, 32, 121, 122, 131, 132, 141 that the charge packets are transported one by one, while in this embodiment during the transport the charge packets are distributed over potential wells under two electrodes. In Table 2 a broken line again indicates how the transport of the charge packet stored under the electrode 132 takes place. This packet reaches at the instant $t_{16}$ (line $p$) a potential well under the electrodes 21, 22. The input terminal 107 (electrode 21) is high (1) at that instant and now remains high as yet so that at the instant $t_{17}$ upon activation of $\varphi_1$ (clock line 116) the output of the first stage 101 of the shift register 13 becomes low (0) (line $g$). As a result, at the instant $t_{10}$ the output of the next stage and hence the electrode 31 becomes high (1) (line $r$) under the influence of $\varphi_2$ (clock line 117). Similar changes take place in the following stages at the instants $t_{19}$ to $t_{23}$ until at the instant $t_{24}$ (line $x$) the electrodes 21, 22, 31, 32, 121, 122, 131, 132, 141 have a 101010101 pattern. From now at the instants $t_{24}$ to $t_{26}$ (lines $x$, $y$, $z$) integration under the odd-numbered electrodes is possible.

In Figure 4 and Table 3, for a slightly different device there is indicated how for a complete image sensor device the control for integration, charge transport, storage in the memory part etc. can take place. The device differs from that shown in Figures 2 and 3 in sofar that the electrodes 21 and 51 are now not connected to the input terminals 107, 107' of the registers 13, 13', but are driven by the output of the first stage 101 in each of these registers. For the sake of simplicity, the device is limited to an image sensor part and a memory part each having six electrodes.

At the instant $t_1$ (line $a$ in Table 3), the electrodes 22, 32 and 82 in the image sensor part are high (1) so that under these electrodes a charge pattern corresponding to the image to be displayed is collected under these electrodes. The electrodes 22, 32 and 82 remain at this voltage during the period $t_1$ to $t_3$ because the input terminal 107 of the register 13 remains at a high voltage (1). This voltage becomes low (0) at $t_4$, but due to the fact that then $\varphi_2$ is active (line $d$), this does not yet influence directly the electrode 22. In the memory part the electrodes 51, 52, 151, 152, 41 and 42 are furnished with clock signals *inter alia* due to the fact that the voltage at the input terminal 107' alternates periodically between high and low in such a manner that at the instant $t_6$ a potential well is situated under the electrode 42, while a potential barrier is situated under the electrodes 41, 52 (line $f$). In fact, at the instant $t_5$, due to the fact that the input terminal 107 becomes low at the instant $t_4$, as soon as the clock line 116 ($\varphi_1$) becomes high, the output of the first stage 101 of the register 13 and hence the electrode 21 becomes high. The potential well initially present under the electrode 22 is now distributed under the electrodes 21 and 22 (line $e$).

At the instant $t_6$, this charge packet is situated, due to the said choice of clock pulse signals, in a potential well under the electrodes 42, 21, after which it is transported during the instants $t_7$ to $t_{11}$ to a potential well under the electrodes 51, 52. Meanwhile, by supplying a periodical signal at the input terminal 107, the electrodes 31, 32, 81 and 82 are also furnished in a similar manner with clock pulse signals so that charge generated under the electrodes 32 and 82 is also transported to the memory part and is stored therein under the electrodes 151 and 41, respectively.

It should be noted that in the part in which transport takes place the potential wells as well as the potential barriers have a width of two electrode widths, while at the storage stage this width is equal to only one electrode width.

From the instant $t_{10}$ (line $j$), the input 107' of a register 13' becomes temporarily low (0). This does not influence at $t_{10}$ the electrode 51 because $\varphi_2$ (clock line 117) is active at that instant. At the instant $t_{11}$, however, the clock line 116 $\varphi_1$ and hence also the output of the first stage becomes high, that is to say that the electrode 51 becomes high (1).

TABLE 3

| Instant | Clock | 107' | 107 | 51 | 52 | 151 | 152 | 41 | 42 | 21 | 22 | 31 | 32 | 81 | 82 | Line |
|---|---|---|---|---|---|---|---|---|---|---|---|---|---|---|---|---|
| | | | | | | memory part | | | | | Image sensor part | | | | | |
| $t_1$ | $\varphi_1$ | 1 | 1 | 0 | 0 | 1 | 1 | 0 | 0 | 0 | 1 | 0 | 1 | 0 | 1 | a |
| $t_2$ | $\varphi_2$ | 0 | 1 | 0 | 1 | 1 | 0 | 0 | 1 | 0 | 1 | 0 | 1 | 0 | 1 | b |
| $t_3$ | $\varphi_1$ | 0 | 1 | 1 | 1 | 0 | 0 | 1 | 1 | 0 | 1 | 0 | 1 | 0 | 1 | c |
| $t_4$ | $\varphi_2$ | 1 | 0 | 1 | 0 | 0 | 1 | 1 | 0 | 0 | 1 | 0 | 1 | 0 | 1 | d |
| $t_5$ | $\varphi_1$ | 1 | 0 | 0 | 0 | 1 | 1 | 0 | 0 | 1 | 1 | 0 | 1 | 0 | 1 | e |
| $t_6$ | $\varphi_2$ | 0 | 1 | 0 | 1 | 1 | 0 | 0 | 1 | 1 | 0 | 0 | 1 | 0 | 1 | f |
| $t_7$ | $\varphi_1$ | 0 | 1 | 1 | 1 | 0 | 0 | 1 | 1 | 0 | 0 | 1 | 1 | 0 | 1 | g |
| $t_8$ | $\varphi_2$ | 1 | 0 | 1 | 0 | 0 | 1 | 1 | 0 | 0 | 1 | 1 | 0 | 0 | 1 | h |
| $t_9$ | $\varphi_1$ | 1 | 0 | 0 | 0 | 1 | 1 | 0 | 0 | 1 | 1 | 0 | 0 | 1 | 1 | i |
| $t_{10}$ | $\varphi_2$ | 0 | 1 | 0 | 1 | 1 | 0 | 0 | 1 | 1 | 0 | 0 | 1 | 1 | 0 | j |
| $t_{11}$ | $\varphi_1$ | 0 | 1 | 1 | 1 | 0 | 0 | 1 | 1 | 0 | 0 | 1 | 1 | 0 | 0 | k |
| $t_{12}$ | $\varphi_2$ | 0 | 0 | 1 | 0 | 0 | 1 | 1 | 0 | 0 | 1 | 1 | 0 | 0 | 1 | l |
| $t_{13}$ | $\varphi_1$ | 0 | 0 | 1 | 0 | 1 | 1 | 0 | 0 | 1 | 1 | 0 | 0 | 1 | 1 | m |
| $t_{14}$ | $\varphi_2$ | 0 | 1 | 1 | 0 | 1 | 0 | 0 | 1 | 1 | 0 | 0 | 1 | 1 | 0 | n |
| $t_{15}$ | $\varphi_1$ | 0 | 1 | 1 | 0 | 1 | 0 | 1 | 1 | 0 | 0 | 1 | 1 | 0 | 0 | o |
| $t_{16}$ | $\varphi_2$ | 0 | 0 | 1 | 0 | 1 | 0 | 1 | 0 | 0 | 1 | 1 | 0 | 0 | 1 | p |
| $t_{17}$ | $\varphi_1$ | 0 | 0 | 1 | 0 | 1 | 0 | 1 | 0 | 1 | 1 | 0 | 0 | 1 | 1 | q |
| $t_{18}$ | $\varphi_2$ | 0 | 0 | 1 | 0 | 1 | 0 | 1 | 0 | 1 | 0 | 0 | 1 | 1 | 0 | r |
| $t_{19}$ | $\varphi_1$ | 0 | 0 | 1 | 0 | 1 | 0 | 1 | 0 | 1 | 0 | 1 | 1 | 0 | 0 | s |
| $t_{20}$ | $\varphi_2$ | 1 | 0 | 1 | 0 | 1 | 0 | 1 | 0 | 1 | 0 | 1 | 0 | 0 | 1 | t |
| $t_{21}$ | $\varphi_1$ | 1 | 0 | 0 | 0 | 1 | 0 | 1 | 0 | 1 | 0 | 1 | 0 | 1 | 1 | u |
| $t_{22}$ | $\varphi_2$ | 0 | 0 | 0 | 1 | 1 | 0 | 1 | 0 | 1 | 0 | 1 | 0 | 1 | 0 | v |
| $t_{23}$ | $\varphi_1$ | 0 | 0 | 1 | 1 | 0 | 0 | 1 | 0 | 1 | 0 | 1 | 0 | 1 | 0 | w |
| $t_{24}$ | $\varphi_2$ | 1 | 0 | 1 | 0 | 0 | 1 | 1 | 0 | 1 | 0 | 1 | 0 | 1 | 0 | x |

The electrode 52 remains high, but becomes low at the instant $t_{12}$ by the activation of $\varphi_2$, while at the input terminal 107' no change occurs. At the instant $t_{13}$, the electrode 151 becomes permanently high, while at $t_{14}$ the electrode 152 becomes permanently low so that a potential well for the following charge packet is formed under the electrode 151. This is continued until in the memory part all electrodes have alternately a high and a low potential and the charge packets are transported from the image sensor part to the memory part (instant $t_{16}$, line p). The input 107 becomes low at the instant $t_{16}$ so that in the same manner as just described for the memory part the electrodes in the image sensor part are alternately brought again to a high and a low voltage ($t_{17}$ to $t_{21}$, line g to line u), although in this case for interlacing purposes the odd-numbered electrodes 21, 31 and 81 have a high potential. From the instant $t_{20}$, the input terminal 107' of the register 13' is no longer kept at a low level (0), but again such voltages are supplied that gradually a transport or clock signal appears again at the electrodes 51, 52, 151, 152, 41, 42.

9

Figure 5 shows (in part) a preferred embodiment of the register 13, which is realized by means of C-MOS technology. In this case, each stage 1a of the register comprises an inverter circuit composed of a *p*-type MOS transistor 109 and an *n*-type MOS transistor 108 which are connected in series between a positive supply line 110 and an earth line 111. The gate electrodes of the transistors 108 and 109 are interconnected; the output of the inverter circuit (point 113, at which the transistors 108 and 109 are interconnected) determines the voltage at the electrodes 21, 22, 31, 32 of the charge-coupled semi-conductor device. This voltage is maintained due to the fact that, dependent upon the condition of the output (high or low), a parasitic capacitance 103 is charged or not charged by the switching behaviour of the inverter circuit. This switching behaviour is determined by the clock pulse electrodes 116, 117 which switch on or off an *n*-type MOS transistor 106 so that information of the preceding stage is passed on to the common gate electrode of the transistors 108 and 109. If, for example, the clock line 116 becomes high, the transistor 106 becomes conducting (analogous to switching on the switching elements 106 in Figure 3). Dependent upon the voltage at the electrode 22, the output 113 assumes a complementary voltage by the operation of the inverter circuit 108, 109. As described above, however, 113 changes only if in a preceding stage by activation of the clock pulse line 117 the voltage at the output 113' has changed (due to a change at the capacitance 103').

Figure 6 shows diagrammatically an equivalent of a part of the device shown in Figure 2, in which parts of the register 13 are realized on both sides of the system of electrodes 21, 22... 141, 142. For the sake of simplicity, in this embodiment no clock lines are shown.

The first electrode 21 is directly controlled by the input terminal 107; in this embodiment, the electrode 21 is located between the input terminal 107 and the actual input of the first stage 101, but this is not necessary. The electrodes 22, 31, 32 are connected like in Figure 2, to the outputs of the first, the second and the third stage, respectively. The other end of the electrode 32 is connected to an input terminal 107'' of a second series of three stages 101, the outputs of which determine the voltage at the electrodes 121, 122 and 131. The electrode 131 forms in turn a connection between the output of the second subregister and the input of a next subregister of three stages 101. In this manner, the register 13 can be subdivided into a number of subregisters, which are realized on both sides of the electrode system, which is advantageous from a viewpoint of lay-out technique.

Of course, the invention is not limited to the embodiments shown here. Instead of a two-phase clock, a three-phase clock a four-phase clock or even a monophase clock may also be chosen for controlling the register 13.

Figure 7 shows a part of a register 13 for a three-phase clock with clock lines 116 ($\varphi_1$), 117 ($\varphi_2$), 114 ($\varphi_3$), while Table 4 shows in the same manner as Tables 2 and 3 symbolically the switching behaviour for three-phase transport. In a similar manner, Figure 8 shows a part of a register 13 for a four-phase clock with clock electrodes 116 ($\varphi_1$), 117 ($\varphi_2$), 114 ($\varphi_3$) and 119 ($\varphi_4$) which can furnish the electrodes 21, 22, 23, 24, 31, 32, 33, 34 with voltages for four-phase transport. The associated switching behaviour is shown in Table 5.

It is alternatively possible to choose a register 13 which is controlled by a monophase clock provided that the stages 101 change their states with such a delay that the change of one stage due to the activation of a clock pulse does not influence the next stage, as is the case for edge-triggered stages 101. Figure 9 shows a part of such a register 13 with a clock line 116 ($\varphi_1$) which can furnish the electrodes 21, 22, 23, 24, 31, 32, 33, 34 with voltages for four-phase transport. The associated switching behaviour is shown in Table 6; it should be noted that the lines $t_0$, $t_1$ etc. indicate the change after activation of the clock $\varphi$, in which event the information at the input terminal 107 is present in time, taking into account synchronization times.

EP 0 161 023 B1

TABLE 4

| Instant | Input (107) | Clock | Electrodes | | | | | | | |
|---|---|---|---|---|---|---|---|---|---|---|
| | | | 21 | 22 | 23 | 31 | 32 | 33 | 121 | 122 |
| $t_0$ | 0 | $\varphi_3$ | 0 | 1 | 0 | 1 | 0 | 1 | 0 | 1 |
| $t_1$ | 0 | $\varphi_1$ | 1 | 1 | 0 | 1 | 0 | 1 | 0 | 1 |
| $t_2$ | 0 | $\varphi_2$ | 1 | 0 | 0 | 1 | 0 | 1 | 0 | 1 |
| $t_3$ | 0 | $\varphi_3$ | 1 | 0 | 1 | 1 | 0 | 1 | 0 | 1 |
| $t_4$ | 0 | $\varphi_1$ | 1 | 0 | 1 | 0 | 0 | 1 | 0 | 1 |
| $t_5$ | 0 | $\varphi_2$ | 1 | 0 | 1 | 0 | 1 | 1 | 0 | 1 |
| $t_6$ | 0 | $\varphi_3$ | 1 | 0 | 1 | 0 | 1 | 0 | 0 | 1 |
| $t_7$ | 1 | $\varphi_1$ | 0 | 0 | 1 | 0 | 1 | 0 | 1 | 1 |
| $t_8$ | 1 | $\varphi_2$ | 0 | 1 | 1 | 0 | 1 | 0 | 1 | 0 |
| $t_9$ | 1 | $\varphi_3$ | 0 | 1 | 0 | 0 | 1 | 0 | 1 | 0 |
| $t_{10}$ | 0 | $\varphi_1$ | 1 | 1 | 0 | 1 | 1 | 0 | 1 | 0 |
| $t_{11}$ | 0 | $\varphi_2$ | 1 | 0 | 0 | 1 | 0 | 0 | 1 | 0 |
| $t_{12}$ | 0 | $\varphi_3$ | 1 | 0 | 1 | 1 | 0 | 1 | 1 | 0 |
| $t_{13}$ | 1 | $\varphi_1$ | 0 | 0 | 1 | 0 | 0 | 1 | 0 | 0 |
| $t_{14}$ | 1 | $\varphi_2$ | 0 | 1 | 1 | 0 | 1 | 1 | 0 | 1 |
| $t_{15}$ | 1 | $\varphi_3$ | 0 | 1 | 0 | 0 | 1 | 0 | 0 | 1 |
| $t_{16}$ | 0 | $\varphi_1$ | 1 | 1 | 0 | 1 | 1 | 0 | 1 | 1 |
| $t_{17}$ | 0 | $\varphi_2$ | 1 | 0 | 0 | 1 | 0 | 0 | 1 | 0 |
| $t_{18}$ | 0 | $\varphi_3$ | 1 | 0 | 1 | 1 | 0 | 1 | 1 | 0 |

In this embodiment as well as in the two preceding embodiments, it is assumed that at $t_0$ the input terminals (107) have had a constant value (1 or 0) for a sufficiently long time to adjust under the electrodes a 010101 pattern.

The registers 13 may also be manufactured by means of non-inverting stages, which may then be again interconnected, for example, by means of switching elements (transistors). A device according to the invention having registers 13, 13' with non-inverting stages 101, 101' is shown diagrammatically in Figure 10. In this embodiment, a stage 101 comprises a switching element 106, a non-inverting circuit 120 and a capacitance 103. The capacitances 103 are again connected in an electrically conducting manner to electrodes 21, 22, 31, 32, 121, 122, 131, 132, 141, 142 of an electrode system for charge storage and charge transport, for example in an image sensor part of a device similar to that shown in Figure 2. *Inter alia* in order to be able to apply alternately a low and a high potential to the electrodes 21, 22, 31, 32... 141, 142 during integration, the odd-numbered electrodes 21, 31, 121, 131, 141 and the even-numbered electrodes 22, 32, 122, 132, 142 are connected in an electrically conducting manner to the output stages of separate registers 13 and 13', respectively, which are arranged, for example, on both sides of the electrode system.

A possible realization in complementary MOS technology of such a register stage 101 is shown in Figure 11. Two series arrangements of a *p*-type MOS transistor 109, 109' and an *n*-type MOS transistor 108, 108' are provided between a supply line 110 and an earth line 111. The gate electrodes of the transistors 108 and 109 and 108' and 109', respectively, are interconnected, the common electrode of the transistors 108 and 109 being connected to the junction point of the transistors 108' and 109'. The point 113 at which the transistors 108 and 109 are interconnected determines the voltage at one of the electrodes 21, 22... 141, 142; in the embodiment shown in Figure 11, this point is connected to the electrode 31. The capacitance 103 may be charged or not charged dependent upon the switching behaviour of a preceding stage 101 and is also determined by signals at the input terminal 107 and the clock pulse lines 116 ($\varphi_1$), 117 ($\varphi_2$) and 114 ($\varphi_3$), which switch on or off an $n$-type MOS transistor 106 so that information of the input 107 or a preceding stage may be or may not be passed on. If, for example, in the stage 101 shown in Figure 11 clock line 117 becomes high, the transistor 106 becomes conducting. The output of 101 and hence the electrode 31 then assumes the voltage of the electrode 21, which is connected to the output of the preceding stage. The electrode 31 changes only if at a preceding stage when the clock line 116 becomes high the voltage at the electrode 21 has changed.

Table 7 shows symbolically the switching behaviour of the electrodes 21, 22, 31, 32, 121, 122, 131, 132, 141, 142 if the latter are controlled by means of such registers with non-inverting stages 101. The odd-numbered electrodes 21, 31, 121, 131, 141 are then controlled from the register 13 with stages 101 and an input terminal 107, while the even-numbered electrodes 22, 32, 122, 132, 142 are controlled from the register 13' with stages 101' (see Figure 10).

TABLE 5

| Instant | Clock | Input (107) | Electrodes | | | | | | | |
|---------|-------|-------------|----|----|----|----|----|----|----|----|
| | | | 21 | 22 | 23 | 24 | 31 | 32 | 33 | 34 |
| $t_0$ | $\varphi_4$ | 0 | 0 | 1 | 0 | 1 | 0 | 1 | 0 | 1 |
| $t_1$ | $\varphi_1$ | 0 | 1 | 1 | 0 | 1 | 0 | 1 | 0 | 1 |
| $t_2$ | $\varphi_3$ | 0 | 1 | 1 | 0 | 1 | 0 | 1 | 0 | 1 |
| $t_3$ | $\varphi_4$ | 0 | 1 | 1 | 0 | 1 | 0 | 1 | 0 | 1 |
| $t_4$ | $\varphi_2$ | 1 | 1 | 0 | 0 | 1 | 0 | 1 | 0 | 1 |
| $t_5$ | $\varphi_3$ | 1 | 1 | 0 | 1 | 1 | 0 | 1 | 0 | 1 |
| $t_6$ | $\varphi_1$ | 1 | 0 | 0 | 1 | 1 | 0 | 1 | 0 | 1 |
| $t_7$ | $\varphi_2$ | 1 | 0 | 1 | 1 | 1 | 0 | 1 | 0 | 1 |
| $t_8$ | $\varphi_4$ | 0 | 0 | 1 | 1 | 0 | 0 | 1 | 0 | 1 |
| $t_9$ | $\varphi_1$ | 0 | 1 | 1 | 1 | 0 | 1 | 1 | 0 | 1 |
| $t_{10}$ | $\varphi_3$ | 0 | 1 | 1 | 0 | 0 | 1 | 1 | 0 | 1 |
| $t_{11}$ | $\varphi_4$ | 0 | 1 | 1 | 0 | 1 | 1 | 1 | 0 | 1 |
| $t_{12}$ | $\varphi_2$ | 1 | 1 | 0 | 0 | 1 | 1 | 0 | 0 | 1 |
| $t_{13}$ | $\varphi_3$ | 1 | 1 | 0 | 1 | 1 | 1 | 0 | 1 | 1 |
| $t_{14}$ | $\varphi_1$ | 1 | 0 | 0 | 1 | 1 | 0 | 0 | 1 | 1 |
| $t_{15}$ | $\varphi_2$ | 1 | 0 | 1 | 1 | 1 | 0 | 1 | 1 | 1 |
| $t_{16}$ | $\varphi_4$ | 0 | 0 | 1 | 1 | 0 | 0 | 1 | 1 | 0 |
| $t_{17}$ | $\varphi_1$ | 0 | 1 | 1 | 1 | 0 | 1 | 1 | 1 | 0 |

At the instant $t_0$, all even-numbered electrodes 22, 32, 122, 132, 142 have been high (1) for some time so that integration of charge carriers (electrons) generated due to a radiation image has taken place under these even-numbered electrodes. The input 107 of the register 13 is high (1), but because $\varphi_1$ (line 116) is not active, this does not influence the first stage of the register 13 and hence the electrode 21 controlled by the output of this stage; the other stages, which are connected to the clock line 117 ($\varphi_2$), are not influenced either by the activation of $\varphi_2$ at $t_0$.

At the instant $t_1$, $\varphi_1$ (clock line 116) is high (1). The information at the input terminal 107 which is now high is passed on. The other outputs and electrodes connected thereto (131, 32, 142) which could change due to the activation of $\varphi_1$, remain unchanged because the inputs of the relevant stages (electrodes 121, 22,

12

132) have not changed with respect to the instant $t_0$. The charge which was initially present under the electrode 22 is now present under the electrodes 21, 22.

TABLE 6

| Instant | Input (107) | Electrodes | | | | | | | |
|---|---|---|---|---|---|---|---|---|---|
| | | 21 | 22 | 23 | 24 | 31 | 32 | 33 | 34 |
| $t_1$ | 1 | 0 | 1 | 0 | 1 | 0 | 1 | 0 | 1 |
| $t_2$ | 0 | 1 | 1 | 0 | 1 | 0 | 1 | 0 | 1 |
| $t_3$ | 0 | 1 | 0 | 0 | 1 | 0 | 1 | 0 | 1 |
| $t_4$ | 1 | 0 | 0 | 1 | 1 | 0 | 1 | 0 | 1 |
| $t_5$ | 1 | 0 | 1 | 1 | 0 | 0 | 1 | 0 | 1 |
| $t_6$ | 0 | 1 | 1 | 0 | 0 | 1 | 1 | 0 | 1 |
| $t_7$ | 0 | 1 | 0 | 0 | 1 | 1 | 0 | 0 | 1 |
| $t_8$ | 1 | 0 | 0 | 1 | 1 | 0 | 0 | 1 | 1 |
| $t_9$ | 1 | 0 | 1 | 1 | 0 | 0 | 1 | 1 | 0 |

At the instant $t_2$, $\varphi_3$ (clock line 114) is high (1). Since the clock line 114 controls the first stage of the register 13', the information of the input terminal 107', which is low (0), is passed on to the output of this stage and hence to the electrode 22. The input terminal 107 has meanwhile also obtained a low signal, but this does not influence the electrode 21 because $\varphi_1$ is not active; due to the fact that the electrode 22 becomes low, the charge, which originally was present under the electrode 22, is now present under the electrode 21. The activation of the clock line 114 ($\varphi_3$) could further influence the electrodes 121 and 132, but the latter retain their values (0 and 1, respectively) because the outputs of the preceding stages and the electrodes 31 and 122, respectively, are unchanged.

At the instant $t_3$, $\varphi_2$ (clock line 117) is high. The fact that the input terminal 107' has become high, does not influence the output of the first stage 101' of the register 13' and hence the electrode 22.

The clock line 117 ($\varphi_2$) does influence the electrode 31 so that the high voltage (1) which the electrode 21 obtained at the instant $t_1$ due to $\varphi_1$ (clock line 116) is now passed on to the electrode 31. The remaining outputs (141, 122) of stages 101, 101' controlled by $\varphi_2$ still remain unchanged. At the following instants, such input voltages are supplied at the input terminals 107, 107' that due to the associated clock pulse pattern at the clock lines 116, 117, 114 charge transport will take place under an increasing number of electrodes, as clearly appears from Table 7. At the instant $t_9$, the charge, which until then was concentrated under the electrode 142, is distributed under the electrodes 141, 142, after which at the instants $t_{10}$ to $t_{14}$ this discharge is shifted to the electrode 32.

13

# EP 0 161 023 B1

## TABLE 7

| Instant | Clock | Inputs | | Electrodes | | | | | | | | | |
|---|---|---|---|---|---|---|---|---|---|---|---|---|---|
| | | 107 | 107' | 21 | 22 | 31 | 32 | 121 | 122 | 131 | 132 | 141 | 142 |
| $t_0$ | $\varphi_2$ | 1 | 0 | 0 | 1 | 0 | 1 | 0 | 1 | 0 | 1 | 0 | 1 |
| $t_1$ | $\varphi_1$ | 1 | 0 | 1 | 1 | 0 | 1 | 0 | 1 | 0 | 1 | 0 | 1 |
| $t_2$ | $\varphi_3$ | 0 | 0 | 1 | 0 | 0 | 1 | 0 | 1 | 0 | 1 | 0 | 1 |
| $t_3$ | $\varphi_2$ | 0 | 1 | 1 | 0 | 1 | 1 | 0 | 1 | 0 | 1 | 0 | 1 |
| $t_4$ | $\varphi_1$ | 0 | 1 | 0 | 0 | 1 | 0 | 0 | 1 | 0 | 1 | 0 | 1 |
| $t_5$ | $\varphi_3$ | 1 | 1 | 0 | 1 | 1 | 0 | 1 | 1 | 0 | 1 | 0 | 1 |
| $t_6$ | $\varphi_2$ | 1 | 0 | 0 | 1 | 0 | 0 | 1 | 0 | 0 | 1 | 0 | 1 |
| $t_7$ | $\varphi_1$ | 1 | 0 | 1 | 1 | 0 | 1 | 1 | 0 | 1 | 1 | 0 | 1 |
| $t_8$ | $\varphi_3$ | 0 | 0 | 1 | 0 | 0 | 1 | 0 | 0 | 1 | 0 | 0 | 1 |
| $t_9$ | $\varphi_2$ | 0 | 1 | 1 | 0 | 1 | 1 | 0 | 1 | 1 | 0 | 1 | 1 |
| $t_{10}$ | $\varphi_1$ | 0 | 1 | 0 | 0 | 1 | 0 | 0 | 1 | 0 | 0 | 1 | 0 |
| $t_{11}$ | $\varphi_3$ | 1 | 1 | 0 | 1 | 1 | 0 | 1 | 1 | 0 | 1 | 1 | 0 |
| $t_{12}$ | $\varphi_2$ | 1 | 0 | 0 | 1 | 0 | 0 | 1 | 0 | 0 | 1 | 0 | 0 |
| $t_{13}$ | $\varphi_1$ | 1 | 0 | 1 | 1 | 0 | 1 | 1 | 0 | 1 | 1 | 0 | 1 |
| $t_{14}$ | $\varphi_3$ | 0 | 0 | 1 | 0 | 0 | 1 | 0 | 0 | 1 | 0 | 0 | 1 |

The further variation is not shown in Table 7, but is analogous to that from $t_9$. In the same manner as described for the device shown in Figure 2, after reading the information for interlacing by means of a high (1) signal at the input 107 and a low signal at the input 107' a 1010101010 pattern can be obtained under the electrodes 21, 22, 31, 32, 121, 122, 131, 132, 141, 142, after which integration is possible under the odd-numbered electrodes.

Several variations are also possible in the realization of the register 13 both with respect to the construction of the stages and to the technology used. For example, it is possible to choose a static shift register, in which the stages comprise, for example, cross-coupled transistors.

Besides, the invention may be applied to numerous charge-coupled semiconductor devices, such as, for example, series/parallel/series memories, the aforementioned delay lines and multiplexers. It may also be applied to other types of radiation-sensitive devices, for example, to line sensors.

Furthermore, in the device shown in Figures 10, 11, the electrodes may be connected to the junction point 113' of the transistors 108' and 109'.

Finally, Figure 12 shows an embodiment, in which an electrode system 21, 22, 23, 24, 31, 32, 33, 34..., which is suitable for four-phase transport, is controlled by two shift registers 13, 13' with inverting stages which have a common input terminal 107. The first stage 101 of the shift register 13 is connected to the electrode 21 and is controlled by a clock line 116 ($\varphi_1$), while the second stage is connected to the electrode 22 and is controlled by the clock line 117 ($\varphi_2$). The next two stages are again controlled by the clock lines 116, 117 and are connected to electrodes 31, 32. Similarly, the first two stages 101 of the shift register 13' are connected to electrodes 23, 24 and are controlled by clock lines 114 ($\varphi_3$) and 119 ($\varphi_4$). The next two stages of the register 13' are again controlled by the clock lines 114, 119 and are connected to electrodes 33, 34. Thus, it is achieved that, for example, the electrodes 21, 23, 31, 33, which are generally realized in one wiring layer, are driven alternately from the registers 13 and 13'. Thus, wiring problems are avoided, which occur especially when different electrodes are driven from several stages located beside the electrodes. Moreover, in contradistinction with the embodiment shown in Figure 6, it is now not necessary that electrodes of the electrode system are used as through connection between stages 101. The switching behaviour of the device shown in Figure 11 is shown symbolically in Table 8.

14

TABLE 8

| Instant | Clock | Input (107) | Electrodes | | | | | | | |
|---|---|---|---|---|---|---|---|---|---|---|
| | | | 21 | 22 | 23 | 24 | 31 | 32 | 33 | 34 |
| $t_0$ | $\varphi_4$ | 1 | 1 | 0 | 1 | 0 | 1 | 0 | 1 | 0 |
| $t_1$ | $\varphi_1$ | 1 | 0 | 0 | 1 | 0 | 1 | 0 | 1 | 0 |
| $t_2$ | $\varphi_2$ | 1 | 0 | 1 | 1 | 0 | 1 | 0 | 1 | 0 |
| $t_3$ | $\varphi_3$ | 1 | 0 | 1 | 0 | 0 | 1 | 0 | 1 | 0 |
| $t_4$ | $\varphi_4$ | 0 | 0 | 1 | 0 | 1 | 1 | 0 | 1 | 0 |
| $t_5$ | $\varphi_1$ | 0 | 1 | 1 | 0 | 1 | 0 | 0 | 1 | 0 |
| $t_6$ | $\varphi_2$ | 0 | 1 | 0 | 0 | 1 | 0 | 1 | 1 | 0 |
| $t_7$ | $\varphi_3$ | 0 | 1 | 0 | 1 | 1 | 0 | 1 | 0 | 0 |
| $t_8$ | $\varphi_4$ | 1 | 1 | 0 | 1 | 0 | 0 | 1 | 0 | 1 |
| $t_9$ | $\varphi_1$ | 1 | 0 | 0 | 1 | 0 | 1 | 1 | 0 | 1 |
| $t_{10}$ | $\varphi_2$ | 1 | 0 | 1 | 1 | 0 | 1 | 0 | 0 | 1 |
| $t_{11}$ | $\varphi_3$ | 1 | 0 | 1 | 0 | 0 | 1 | 0 | 1 | 1 |
| $t_{12}$ | $\varphi_4$ | 0 | 0 | 1 | 0 | 1 | 1 | 0 | 1 | 0 |

## Claims

1. A charge-coupled device, comprising a semiconductor body in which at a major surface at least one charge transport channel is defined, and which is provided at said surface with a row of electrodes at which a control signal for storage and a clock signal for charge transport can be supplied, at least one shift register being provided which can be controlled by a mono- or multiphase clock and which has several stages, the electrodes of said row being separately connected in an electrically conducting manner to stages of the shift register, characterized in that said shift register is divided into a plurality of sub-shift registers which are realized on both sides of the row of electrodes, wherein two subsequent subregisters provided on different sides of the row of electrodes are interconnected by one electrode of said row of electrodes.

2. A charge-coupled device as claimed in Claim 1, characterized in that each stage of the shift register comprises one single amplifier or inverter and one single switch as interconnection between the amplifiers or inverters of subsequent stages.

3. A charge coupled device as claimed in Claim 1 or 2, characterized in that each stage of the shift register comprises an inverter having two complementary MOS transistors.

## Patentansprüche

1. Ladungsgekoppelte Anordnung mit einem Halbleiterkörper, in dem auf einer Hauptoberfläche mindestens ein Ladungstransportkanal definiert ist und der an der genannten Oberfläche mit mindestens einer Reihe von Elektroden versehen ist, denen zur Ladungsspeicherung ein Einstellsignal und zum Ladungstransport ein Taktimpulssignal zugeführt werden kann, wobei mindestens ein Schieberegister vorgesehen ist, das von einem Ein- oder Mehrphasentaktimpulsgenerator mit mehreren Stufen gesteuert werden kann, wobei die Elektroden dieser Reihe elektrisch leitend einzeln mit den Stufen des Schieberegisters verbunden sind, dadurch gekennzeichnet, dass das genannte Schieberegister in eine Anzahl Teilschieberegister auf beiden Seiten der Elektrodenreihe aufgeteilt ist, wobei zwei aufeinanderfolgende Teilregister auf unterschiedlichen Seiten durch eine Elektrode der genannten Elektrodenreihe verbunden sind.

2. Ladungsgekoppelte Anordnung nach Anspruch 1, dadurch gekennzeichnet, dass jede Stufe des Schieberegisters einen einzigen Verstärker oder Wandler aufweist, sowie einen einzigen Schalter als Verbindung zwischen den Verstärken oder Wandlern der jeweiligen aufeinanderfolgenden Stufen.

3. Ladungsgekoppelte Anordnung nach Anspruch 1 oder 2, dadurch gekennzeichnet, dass jede Stufe des Schieberegisters einen Wandler mit zwei komplementären MOS-Transistoren aufweist.

# EP 0 161 023 B1

**Revendications**

1. Dispositif à couplage de charges comportant un corps semiconducteur dans lequel, à une surface principale, est défini au moins un canal de transport de charges et qui, sur ladite surface, est muni d'un alignement d'électrodes auquel peuvent être appliqués un signal de commande pour le stockage et un signal d'horloge pour le transport de charges, dispositif dans lequel est prévu au moins un registre à décalage pouvant être commandé par une horloge monophasée ou polyphasée et présentant plusieurs étages, les électrodes dudit alignement étant reliées séparément en conduction électrique à des étages du registre à décalage, caractérisé en ce que ledit registre à décalage est divisé en une pluralité de sous-registres à décalage réalisés des deux côtés de l'alignement d'électrodes, dans lequel deux sous-registres successifs prévus de différents côtés de l'alignement d'électrodes sont reliés entre aux par l'une des électrodes dudit alignement d'électrodes.

2. Dispositif à couplage de charges selon la revendication 1, caractérisé en ce que chaque étage du registre à décalage comporte un seul amplificateur ou inverseur et un seul commutateur comme liaison entre les amplificateurs ou inverseurs d'étages successifs.

3. Dispositif à couplage de charges selon la revendication 1 ou 2, caractérisé en ce que chaque étage du registre à décalage comporte un inverseur ayant deux transistors MOS complémentaires.

FIG.1

FIG.3

1

FIG.2

FIG. 4

FIG. 5

FIG. 6

**EP 0 161 023 B1**

FIG.7

FIG.8

FIG.9

FIG.10

4

FIG.11

FIG.12